(19) Europäisches Patentamt
European Patent Office
Office européen des brevets

(11) **EP 4 518 151 A1**

(12) **EUROPEAN PATENT APPLICATION**

(43) Date of publication:
**05.03.2025 Bulletin 2025/10**

(21) Application number: **24196651.4**

(22) Date of filing: **27.08.2024**

(51) International Patent Classification (IPC):
**H03F 1/02** (2006.01)          **H03F 1/32** (2006.01)
**H03F 3/195** (2006.01)        **H03F 3/213** (2006.01)
**H03F 3/24** (2006.01)

(52) Cooperative Patent Classification (CPC):
**H03F 1/0255; H03F 1/32; H03F 3/195; H03F 3/213; H03F 3/245;** H03F 2200/451

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.08.2023 KR 20230115736**

(71) Applicant: **Samsung Electronics Co., Ltd**
**Suwon-si, Gyeonggi-do 16677 (KR)**

(72) Inventors:
• **YOO, Kyungwoo**
**16677 Suwon-si (KR)**
• **HUR, Joonhoi**
**16677 Suwon-si (KR)**

(74) Representative: **Marks & Clerk LLP**
**15 Fetter Lane**
**London EC4A 1BW (GB)**

(54) **POWER AMPLIFIER CONTROL DEVICE AND OPERATION METHOD THEREFOR**

(57)    A power amplifier control device includes a measuring circuit and a supply voltage regulation circuit. The measured circuit measures an adjacent channel leakage ratio (ACLR) of a power amplifier to generate a measured ACLR. The supply voltage regulation circuit determines a regulated supply voltage from an ACLR model defined based on a change level of a supply voltage of the power amplifier and a change level of the measured ACLR defined, and transfers the regulated supply voltage to the power amplifier. The measured ACLR is a difference between a reference ACLR and the measured ACLR.

## FIG. 1

EP 4 518 151 A1

**Description**

BACKGROUND

1. Technical Field

Embodiments of the present disclosure described herein are directed to a power amplifier, and more particularly to a device for controlling the power amplifier and a method of operating the power amplifier.

2. Discussion of Related Art

Various wireless communication devices, such as smartphones, tablets, and Internet of Things (IoT) devices, include a power amplifier (PA) for amplifying power of a wireless signal. A wireless signal passing through the power amplifier may cause interference in adjacent channels around a target channel since the power amplifier has a non-linear characteristic. An adjacent channel leakage ratio (ACLR) value indicates an amount of the interference. The ACLR value may be regulated such that the amount of interference does not exceed a specific value.

However, the power amplifier may operate inefficiently even when its output signal satisfies the required ACLR value.

SUMMARY

Embodiments of the present disclosure provide a device for controlling a power amplifier (e.g., a power amplifier control device) and a method of operating the same that may increase the efficiency of the power amplifier.

According to an embodiment of the present disclosure, a power amplifier control device includes a measuring circuit and a supply voltage regulation circuit. The measuring circuit measures an adjacent channel leakage ratio (ACLR) of a power amplifier to generate a measured ACLR. The supply voltage regulation circuit determines a regulated supply voltage from an ACLR model defined based on a change level of a supply voltage of the power amplifier and a change level of the measured ACLR, and transfers the regulated supply voltage to the power amplifier. The change level of the measured ACLR is a difference between a reference ACLR and the measured ACLR.

According to an embodiment of the present disclosure, a method of operating a power amplifier control device includes measuring an adjacent channel leakage ratio (ACLR) of a power amplifier to generate a measured ACLR, determining a regulated supply voltage from an ACLR model defined based on a change level of a supply voltage of the power amplifier and a change level of the measured ACLR, and transferring the regulated supply voltage to the power amplifier. The measured ACLR is a difference between a reference ACLR and the measured ACLR.

According to an embodiment of the present disclosure, an electronic device includes a memory storing at least one instruction, and at least one processor that executes the at least one instruction, and the at least one instruction, when executed, causes the at least one processor to measure an adjacent channel leakage ratio (ACLR) of a power amplifier to generate a measured ACLR, to determine a regulated supply voltage from an ACLR model defined based on a change level of a supply voltage of the power amplifier and a change level of the measured ACLR, and to transfer the regulated supply voltage to the power amplifier. The change level of the measured ACLR is a difference between a reference ACLR and the measured ACLR.

At least some of the above and other features of the invention are set out in the claims.

BRIEF DESCRIPTION OF THE FIGURES

FIG. 1 illustrates a power amplifier control device according to an embodiment.

FIG. 2 illustrates an ACLR model according to an embodiment.

FIG. 3 illustrates an ACLR model according to an embodiment.

FIGS. 4 and 5 illustrate a supply voltage regulation and a change level of an ACLR according to the regulation in a power amplifier control device according to an embodiment.

FIG. 6 illustrates a power amplifier control device according to an embodiment.

FIG. 7 illustrates a power amplifier control device according to an embodiment.

FIG. 8 is a flowchart illustrating a method of operating a power amplifier control device according to an embodiment.

FIG. 9 is a flowchart illustrating a method for measuring an ACLR and obtaining an ACLR change data of a power amplifier control device according to an embodiment.

FIG. 10 is a flowchart illustrating a method for regulating a supply voltage of a power amplifier control device according to an embodiment.

FIG. 11 illustrates a radio frequency (RF) circuit according to an embodiment.

FIG. 12 illustrates a predistortion system according to an embodiment.

FIGS. 13 to 15 are diagrams for describing a predistortion operation of an RF circuit according to an embodiment.

FIG. 16 illustrates a predistortion system according to an embodiment.

FIG. 17 illustrates an operation of a predistortion circuit according to an embodiment.

FIG. 18 illustrates a method for measuring a predistortion and an ACLR of an RF circuit according to an embodiment.

FIG. 19 is a flowchart illustrating a method for regulating a predistortion and a supply voltage of an RF circuit according to an embodiment.

FIG. 20 illustrates a wireless communication device according to an embodiment.

FIG. 21 illustrates an electronic device according to an embodiment.

## DETAILED DESCRIPTION

Hereinafter, embodiments of the present disclosure are described in detail and clearly to such an extent that one of ordinary skill in the art may implement the present disclosure.

## Supply voltage regulation of a power amplifier

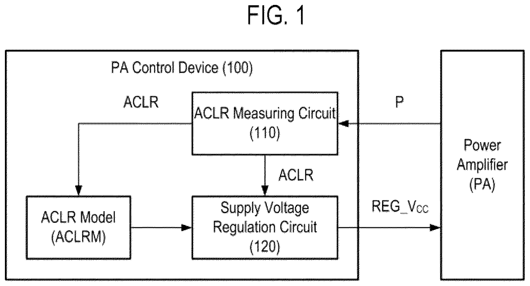

FIG. 1 illustrates a power amplifier control device according to an embodiment.

Referring to FIG. 1, a power amplifier control device 100 according to an embodiment is connected to a power amplifier PA and includes an adjacent channel leakage ratio (ACLR) measuring circuit 110 and a supply voltage regulation circuit 120.

The ACLR measuring circuit 110 may be configured to measure the ACLR of the power amplifier PA. The ACLR measured by the ACLR measuring circuit 110 may occur in an adjacent channel rather than the target channel of the output signal when the output signal of the power amplifier PA is distorted due to nonlinearity of the power amplifier PA.

In an embodiment, the ACLR measuring circuit 110 measures the ACLR based on a difference between the adjacent channel power measured from an adjacent channel of the target channel of the power amplifier PA and the target channel power measured from the target channel. For example, the ACLR measuring circuit 110 may obtain power information 'P' including the power of the target channel from the target channel, the power of a low-band adjacent channel from a low-band adjacent channel with respect to the target channel, and the power of a high-band adjacent channel from a high-band adjacent channel with respect to the target channel, from the power amplifier PA. The ACLR measuring circuit 110 may calculate the difference between the power of the low-band adjacent channel and the power of the target channel as the ACLR of the low-band adjacent channel, and may calculate the difference between the power of the high-band adjacent channel and the power of the target channel as the ACLR of the high-band adjacent channel.

The ACLR measuring circuit 110 may measure the final ACLR that will be used to regulate the supply voltage of the power amplifier PA based on the calculated ACLR of the adjacent channel. For example, the ACLR measuring circuit 110 may determine the final ACLR as the ACLR of the low-band adjacent channel, the ACLR of the high-band adjacent channel, or the mean of the ACLR of the low-band adjacent channel and the ACLR of the high-band adjacent channel. Alternatively, the ACLR measuring circuit 110 apply a specific weight to the sum of the ACLR of the low-band adjacent channel and the ACLR of the high-band adjacent channel, to generate the final ACLR.

In an embodiment, the ACLR measuring circuit 110 may measure a plurality of ACLRs in changing scenarios with respect to the power amplifier PA. For example, a change in the scenario of the power amplifier PA may mean that at least one of a frequency of the target channel, a supply voltage, and other factors related to the power amplifier PA changes. For example, the ACLR measuring circuit 110 may measure the plurality of ACLRs based on a change in at least one of the frequency and supply voltage of the target channel with respect to the power amplifier PA. Data including the plurality of ACLRs measured for each scenario may be defined as an ACLR dataset.

The supply voltage regulation circuit 120 may be configured to regulate a supply voltage to be supplied to the power amplifier PA. The supply voltage regulation circuit 120 may determine a regulated supply voltage $REG\_V_{CC}$ regulated by a change level of the supply voltage from a reference supply voltage of the power amplifier PA, and may transfer the determined regulated supply voltage $REG\_V_{CC}$ to the power amplifier PA. The reference supply voltage may be used as a reference when the supply voltage regulation circuit 120 changes the supply voltage. The change level of the supply voltage may be a difference between the reference supply voltage and the regulated supply voltage $REG\_Vcc$. Accordingly, when the change level of the supply voltage is determined, the supply voltage regulation circuit 120 may determine the difference between the reference supply voltage and the change level of the supply voltage as the regulated supply voltage $REG\_Vcc$.

In an embodiment, the supply voltage regulation circuit 120 determines the regulated supply voltage $REG\_V_{CC}$ based on an ACLR model ACLRM. For example, the ACLR model ACLRM may be defined based on the change level of the supply voltage of the power amplifier PA and the change level of ACLR, which is defined as a difference between a reference ACLR and the ACLR. In an embodiment, the ACLR model ACLRM is a model representing a correlation between the change level of the supply voltage and the change level of the ACLR. In an embodiment, the reference ACLR is an ACLR reference value required for the power amplifier PA, and the ACLR is measured by the ACLR measuring circuit 110. For example, the reference ACLR may be set in various ways depending on the specifications of the communication system. For example, in a 5th Generation (5G) communication system, the reference ACLR may be set to -31dB when operating at a Power Class (PC) of 2 or -30dB when operating at a PC of 3 and a Frequency Range (FR) of 1.

The ACLR model ACLRM may be a model in which the ACLR increases as the change level of the supply voltage increases. In an embodiment, the ACLR model ACLRM has a correlation in which ACLR deterioration occurs as the supply voltage decreases. The ACLR deterioration may mean that the ACLR increases further. Then, when the currently measured ACLR from the power amplifier PA is lower than the reference ACLR, the reference ACLR may still be satisfied by slightly reducing the supply voltage, even though the deterioration of the ACLR occurs.

Therefore, the supply voltage regulation circuit 120 may obtain the change level of the supply voltage corresponding to the change level of a current target ACLR from the ACLR model ACLRM, and may determine the regulated supply voltage $REG\_V_{CC}$ regulated by the change level of the supply voltage. In an embodiment, the regulated supply voltage has a lower value than the reference supply voltage. In addition, the ACLR will deteriorate by a level corresponding to the change level of the ACLR, but the reference ACLR will still be satisfied.

In an embodiment, an ACLR margin value is applied to the reference ACLR. The ACLR margin value may be preset and may be a real number greater than '0'. When the ACLR margin value is applied, the reference ACLR defined at the change level of the ACLR may have a lower value.

At least one embodiment of the present disclosure may increase the efficiency of the power amplifier PA by lowering the supply voltage of the power amplifier PA while still satisfying the reference ACLR. In other words, at least one embodiment of the present disclosure may increase the efficiency of the power amplifier PA as much as possible within a range that satisfies the reference ACLR. In addition, in at least one embodiment of the present disclosure, the supply voltage to be regulated may be efficiently determined based on the defined ACLR model ACLRM, without the need to regulate the supply voltage of the power amplifier PA to various values to obtain the lowest supply voltage that satisfies the reference ACLR.

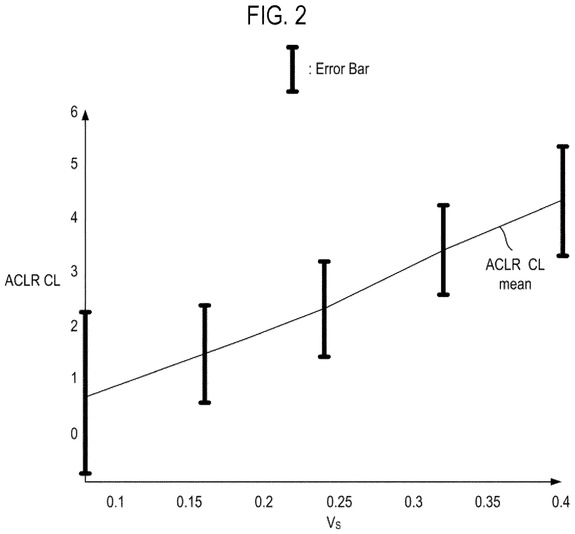

FIG. 2 illustrates an ACLR model according to an embodiment.

Referring to FIG. 2, the ACLR model ACLRM according to an embodiment represents a correlation between a change level $v_s$ of the supply voltage and a change level ACLR CL of the ACLR. For example, as illustrated, an input (or an independent variable) of the ACLR model ACLRM is the change level $v_s$ of the supply voltage, and an output (or a dependent variable) is the change level ACLR CL of the ACLR. The unit of the change level $v_s$ of the supply voltage is volts (V), and the unit of the change level ACLR CL of the ACLR is dB relative to the carrier (dBc). In addition, it will be understood that the input/output values of the ACLR model ACLRM in FIG. 2 are merely illustrated as examples for convenience of description.

In an embodiment, the ACLR model ACLRM is defined based on the correlation between the change data of the ACLR obtained from the ACLR dataset and the change level $v_s$ of the supply voltage. The ACLR dataset may include a plurality of ACLRs measured in various scenarios of the power amplifier. The change data of the ACLR may include various types of data that may be measured from the ACLR dataset. For example, the change data of the ACLR may include at least one of the change level ACLR CL of the ACLR, the mean of the change level ACLR CL of the ACLR, and the standard deviation of the change level ACLR CL of the ACLR, with respect to the ACLR dataset.

In the case of FIG. 2, an output of the ACLR model ACLRM according to the change level $v_s$ of the supply voltage is the mean of the change level ACLR CL of the ACLR, and where an error bar defined as an ACLR change level range corresponding to the standard deviation of the ACLR change level ACLR CL for each specific interval with respect to the change level $v_s$ of the supply voltage may be defined according to the ACLR model ACLRM. The error bar may represent a range of $\pm A\sigma$ (where the 'A' is a real number greater than or equal to 0, and $\sigma$ is the standard deviation of the change level ACLR CL of the ACLR) in the change level $v_s$ of each supply voltage. For example, the 'A' may be set in various ways, when it is assumed that the distribution of the difference between the change level ACLR CL of the ACLR and the mean of the change level ACLR CL of the ACLR follows a Gaussian distribution and an 'm' is set to '3', it may be seen that approximately 99.7% of the change level ACLR CL of the ACLR with respect to the ACLR dataset exists within the error bar. Therefore, the probability that the change level ACLR CL of the ACLR is greater than $\pm 3\sigma$ will be less than 0.15%. When the 'A' is set to a greater value, the regulated supply voltage may be regulated more conservatively.

In an embodiment, when the power amplifier control device determines the change level $v_s$ of the supply voltage based on the mean of the change level ACLR CL of the ACLR, the power amplifier control device may calculate the change level ACLR CL of the ACLR defined as the difference between the reference ACLR and the measured ACLR, and may specify the mean of the change level ACLR CL of the ACLR corresponding to the change level ACLR CL of the ACLR in the ACLR model ACLRM. Thereafter, the power amplifier control device may determine the change level $v_s$ of the supply voltage corresponding to the specified mean and may determine the regulated supply voltage.

For example, when it is assumed that the reference supply voltage is 4.42V, the reference ACLR is -38dBc, and the measured ACLR is -41dBc, the change level ACLR CL of the ACLR is 3dBc. Accordingly, the power amplifier control device may obtain about 0.3V as the change level $v_s$ of the supply voltage corresponding to 3dBc, and may determine 4.12V as the regulated supply voltage by subtracting 0.3V from the reference supply voltage.

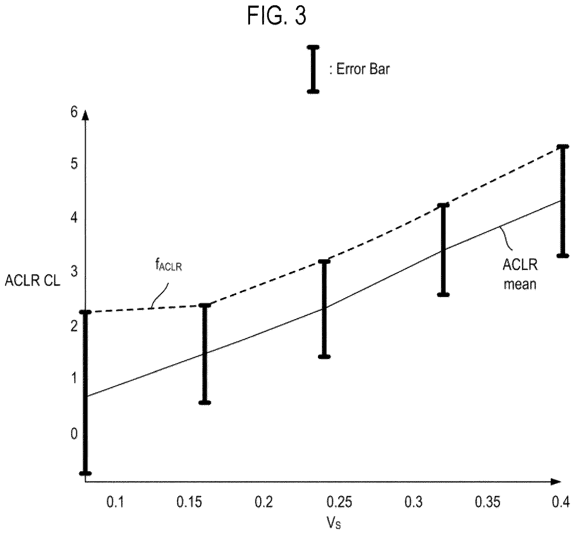

FIG. 3 illustrates an ACLR model according to an embodiment.

Referring to FIG. 3, the ACLR model ACLRM according to an embodiment is defined based on the correlation between ACLR change data and the change level $v_s$ of the supply voltage as illustrated in FIG. 2, and is additionally defined to have an upper limit value $f_{ACLR}$ within the error bar as a dependent variable with respect to the change level $v_s$ of the supply voltage. In an embodiment, the upper limit value $f_{ACLR}$ is the change level ACLR CL of the ACLR that represents the largest value within the error bar with respect the change level $v_s$ of the supply voltage. The upper limit value $f_{ACLR}$ may mean a value when the ACLR deteriorates the most when the scenario of the power amplifier changes based on the same supply voltage.

Therefore, according to an embodiment, when the power amplifier control device determines the change level $v_s$ of the supply voltage based on the upper limit value $f_{ACLR}$, the supply voltage may be regulated more conservatively. This is because the operation of regulating the supply voltage based on the upper limit value $f_{ACLR}$ regulates the supply voltage assuming the case in which ACLR deterioration occurs the most according to scenario changes of the power amplifier. Through regulation of the supply voltage based on the upper limit value $f_{ACLR}$, the power amplifier control device may more safely meet the reference ACLR.

The power amplifier control device 100 may determine the change level $v_s$ of the supply voltage when the change level ACLR CL of the ACLR corresponds to the upper limit value $f_{ACLR}$ in the ACLR model ACLRM, and may determine a difference between the reference supply voltage and the change level $v_s$ of the determined supply voltage as the regulated supply voltage.

For example, assuming that the reference supply voltage is 4.42V, the reference ACLR is -38dBc, and the measured ACLR is -41dBc, the change level ACLR CL of the ACLR is 3dBc. Accordingly, the power amplifier control device may obtain a value between approximately 0.2V to 0.25V, which is the change level $v_s$ of the supply voltage with the upper limit value $f_{ACLR}$ corresponding to 3dBc, and may determine the regulated supply voltage by subtracting the obtained value between 0.2V to 0.25V from the reference supply voltage.

In an embodiment, when the ACLR margin value is applied to the reference ACLR, the power amplifier control device 100 may determine the change level $v_s$ of the supply voltage when a difference between the change level ACLR CL of the ACLR and the ACLR margin value in the ACLR model ACLRM of FIGS. 2 and 3 corresponds to the upper limit $f_{ACLR}$. and the power amplifier control device 100 may also determine the difference between the reference supply voltage and the determined change level $v_s$ of the supply voltage as the regulated supply voltage.

As illustrated in FIGS. 2 and 3 described above, there is a deviation in the ACLR according to scenario change of the power amplifier, but the ACLR model ACLRM defined as the correlation between the change level ACLR CL of the ACLR according to the change level $v_s$ of the supply voltage may have a certain tendency. For example, the ACLR model ACLRM, as illustrated, may be defined as a function in which the change level ACLR CL of the ACLR (or the mean or the upper limit $f_{ACLR}$ of the change level ACLR CL of the ACLR) increases as the change level $v_s$ of the supply voltage increases. Therefore, the power amplifier control device 100 according to an embodiment of the present disclosure may regulate the supply voltage based on the ACLR model ACLRM having the certain tendency, thereby enabling effective supply voltage regulation without a full search with respect to the reference supply voltage.

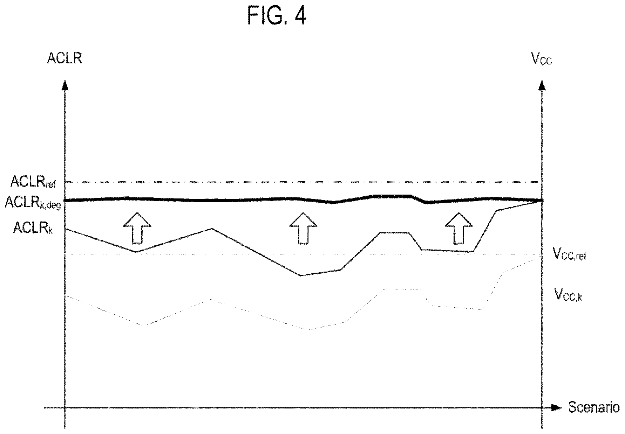

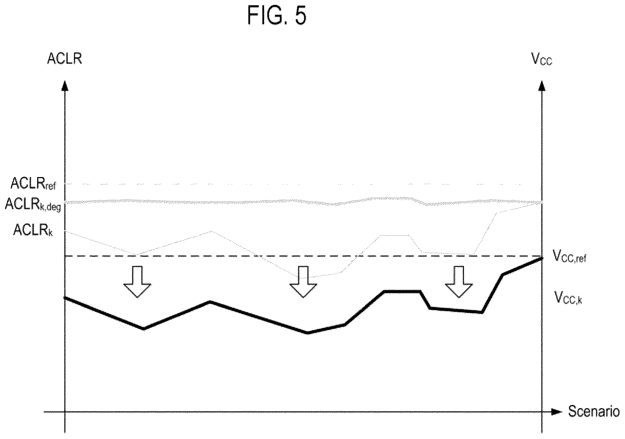

FIGS. 4 and 5 illustrate regulation of a supply voltage and a change level of an ACLR according in a power amplifier control device according to an embodiment. The power amplifier control device may regulate the supply voltage of the power amplifier according to the above-described embodiments.

Referring to FIG. 4, the power amplifier control device 100 may determine the change level $v_s$ of the supply voltage and a regulated supply voltage $V_{CC,k}$ within a range that satisfies a reference ACLR $ACLR_{ref}$ based on the ACLR model ACLRM. The power amplifier control device 100 may determine the regulated supply voltage $V_{CC,k}$ from various scenarios with respect to the power amplifier. Then, the regulated supply voltage $V_{CC,k}$ will be determined for each scenario, so the supply voltage for the operation of the power amplifier will be regulated for each scenario. The regulation of the supply voltage may be in the direction of decreasing from a reference supply voltage $V_{CC,ref}$ within a range that satisfies the reference ACLR $ACLR_{ref}$. Accordingly, the efficiency of the power amplifier may be increased.

In addition, referring to FIG. 5, depending on the regulation of the supply voltage of the power amplifier, the ACLR may be changed. The power amplifier control device 100 may determine the regulated supply voltage $V_{CC,k}$ that satisfies the reference ACLR $ACLR_{ref}$ even if the ACLR changes depending on the change level of the ACLR, which is the difference between the reference ACLR $ACLR_{ref}$ and an ACLR $ACLR_k$ measured for each scenario, and may regulate the supply voltage depending on the determined regulated supply voltage $V_{CC,k}$. Therefore, the measured ACLR $ACLR_k$ may have a value $ACLR_{k,deg}$ that is deteriorated (i.e., the ACLR is increased) rather than the current value, but the reference ACLR $ACLR_{ref}$ will still be satisfied.

At least one of the above-described embodiments may increase efficiency of the power amplifier by reducing the supply voltage while satisfying the ACLR required for the power amplifier.

Hereinafter, various embodiments of the power amplifier control device 100 of FIG. 1 will be described. Additional description of parts overlapping with FIG. 1 may be omitted to avoid redundancy.

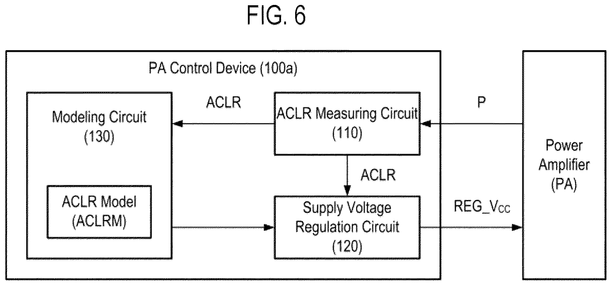

FIG. 6 illustrates a power amplifier control device according to an embodiment.

Referring to FIG. 6, a power amplifier control device 100a according to an embodiment is connected to the power amplifier PA and further includes a modeling circuit 130 in addition to the ACLR measuring circuit 110 and the supply voltage regulation circuit 120.

The modeling circuit 130 may be configured to model the ACLR model ACLRM. In an embodiment, the modeling circuit 130 obtains ACLR change data from the ACLR dataset and models the ACLR model ACLRM based on a correlation between the change level of the supply voltage and the ACLR change data. As described above, the ACLR change data may include at least one of the change level of the ACLR with respect to the ACLR dataset, the mean of the change level of the ACLR, and the standard deviation of the change level of the ACLR.

For example, the modeling circuit 130 may model the ACLR model ACLRM having the change level of the supply voltage as an input (or an independent variable) from the ACLR dataset and the change level of ACLR as an output (or a dependent variable). In an embodiment, the output of the ACLR model ACLRM is the mean of the change level of the ACLR. Alternatively, the output of the ACLR model ACLRM may be the change level of ACLR contained within the ACLR change level range (i.e., the error bar) corresponding to the standard deviation of the change level of the ACLR.

Alternatively, the output of the ACLR model ACLRM may be an upper limit value of the ACLR change level range. In an embodiment, the modeling circuit 130 models the ACLR model ACLRM to have the upper limit value of the ACLR change level range corresponding to the standard deviation of the ACLR change level with respect to the change level of the supply voltage as a dependent variable. Therefore, the supply voltage regulation circuit 120 may determine the change level of the supply voltage when the change level of the ACLR corresponds to the upper limit in the ACLR model ACLRM, and may determine the difference between the reference supply voltage and the determined change level of the supply voltage as the regulated supply voltage.

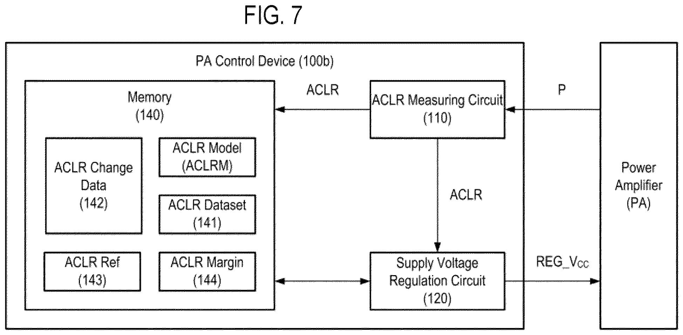

FIG. 7 illustrates a power amplifier control device according to an embodiment.

Referring to FIG. 7, a power amplifier control device 100b according to an embodiment is connected to the power amplifier PA and further includes a memory 140 in addition to the ACLR measuring circuit 110 and the supply voltage regulation circuit 120.

The memory 140 may store the ACLR model ACLRM modeled according to the above-described embodiments. For example, the memory 140 may store the ACLR model ACLRM modeled from the modeling circuit 130 of FIG. 6, and the supply voltage regulation circuit 120 may obtain the change level of the supply voltage when the change level of ACLR corresponds to a specific value in the ACLR model ACLRM stored in the memory 140. In an embodiment, the specific value is the mean of the ACLR change level, the ACLR change level included in the error bar, or the upper limit value, as described above. Thereafter, the supply voltage regulation circuit 120 may determine the difference between the reference supply voltage and the change level of the supply voltage obtained from the memory 140 as the regulated supply voltage.

In addition, the memory 140 may store various types of data for the operation of the power amplifier control device 100b in addition to the ACLR model ACLRM. For example, the memory 140 may store an ACLR dataset 141 including the plurality of ACLRs measured from the ACLR measuring circuit 110, ACLR change data 142 obtained from the ACLR dataset 141, a reference ACLR 143, and an ACLR margin 144.

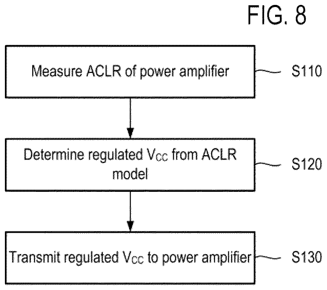

FIG. 8 is a flowchart illustrating a method of operating a power amplifier control device according to an embodiment.

Referring to FIG. 8, in operation S110, the power amplifier control device 100, 100a, or 100b measures the ACLR of the power amplifier. For example, the power amplifier control device 100, 100a, or 100b may obtain the power of the target channel and the power of the adjacent channel according to the above-described embodiments, and may measure the ACLR based on the obtained power.

In operation S 120, the power amplifier control device 100, 100a, or 100b determines the regulated supply voltage Vcc from the ACLR model. The ACLR model may be modeled according to the above-described embodiments. In an embodiment, the power amplifier control device 100, 100a, or 100b calculates the change level of ACLR from the ACLR measured in operation S 110 and the reference ACLR, and obtains the change level of the supply voltage corresponding to the change level of the ACLR from the ACLR model. The power amplifier control device 100, 100a, or 100b may determine the regulated supply voltage Vcc by subtracting the change level of the supply voltage from the reference supply voltage.

In operation S130, the power amplifier control device 100, 100a, or 100b transmits the regulated supply voltage Vcc determined through operation S 120 to the power amplifier. The power amplifier may operate based on the received regulated supply voltage Vcc.

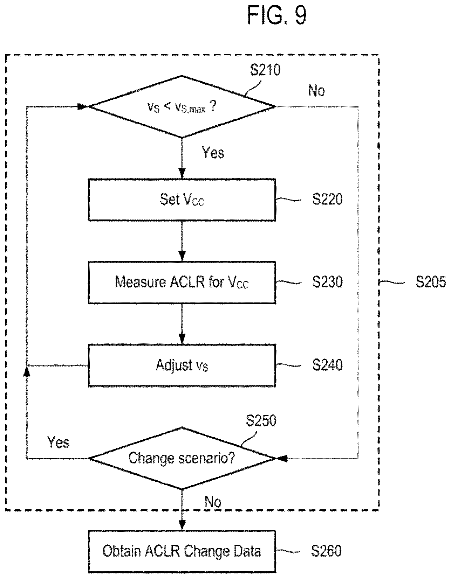

FIG. 9 is a flowchart illustrating a method for measuring an ACLR and obtaining an ACLR change data of a power amplifier control device according to an embodiment.

Referring to FIG. 9, operation S205 is an example of operation S110 (the ACLR measurement of the power amplifier) of FIG. 8. Operation S205 may include operation S210 to operation S250.

In operation S210, the power amplifier control device 100, 100a, or 100b determines whether the change level $v_s$ of the current supply voltage is less than a maximum value $v_{s,max}$. The change level $v_s$ of the supply voltage may be any real number greater than zero.

When the change level $v_s$ of the supply voltage is less than the maximum value $v_{s,max}$, in operation S220, the power amplifier control device 100, 100a, or 100b sets the supply voltage Vcc. For example, the power amplifier control device 100, 100a, or 100b may determine the supply voltage Vcc by subtracting the change level $v_s$ of the supply voltage Vcc from the reference supply voltage.

In operation S230, the power amplifier control device 100, 100a, or 100b measures the ACLR from the power amplifier operating at the determined supply voltage Vcc. In operation S240, the power amplifier control device 100, 100a, or 100b adjusts the change level $v_s$ of the current supply voltage. For example, the power amplifier control device 100, 100a, or 100b may increase the change level $v_s$ of the supply voltage in units of preset change intervals.

The power amplifier control device 100, 100a, or 100b may repeat operations S210 to S240 until the change level $v_s$ of the supply voltage reaches the maximum value $v_{s,max}$. When the change level of the supply voltage reaches the maximum value $v_{s,max}$, in operation S250, the power amplifier control device 100, 100a, or 100b may determine whether to change the scenario. For example, a change in scenario may mean a change in the frequency of the target channel of the power amplifier.

When the scenario is changed, the power amplifier control device 100, 100a, or 100b may repeat operations S210 to S240 with respect to the power amplifier in the changed scenario.

When the scenario is not changed, in operation S260, the power amplifier control device 100, 100a, or 100b may obtain the ACLR change data based on a plurality of ACLRs obtained through operations S210 to S250.

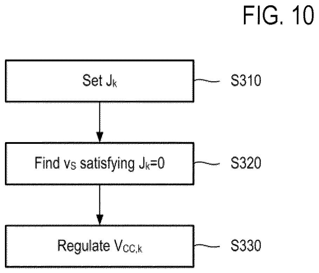

FIG. 10 is a flowchart illustrating a method for regulating a supply voltage of a power amplifier control device according to an embodiment.

Referring to FIG. 10, in operation S310, the power amplifier control device 100, 100a, or 100b sets a target variable $J_k$. In an embodiment, the target variable $J_k$ is defined as Equation 1 below.

$$J_k = f_{ACLR}(v_s) + ACLR_k - (ACLR_{ref} - ACLR_{margin}) \qquad \text{[Equation 1]}$$

In this case, 'k' is a natural number and means a specific scenario of the power amplifier. In an embodiment, when 'k' changes, factors such as the frequency of the target channel of the power amplifier change. In an embodiment, $f_{ACLR}(v_s)$ may refer to the output (e.g., the change level of the ACLR, the mean of the change level of the ACLR, or the upper limit value of the ACLR) of the ACLR model described above, $v_s$ refers to the change level of the supply voltage, $ACLR_k$ refers to the ACLR measured in a specific scenario, $ACLR_{ref}$ refers to the reference ACLR, and $ACLR_{margin}$ refers to the ACLR margin. As the $ACLR_{margin}$ is set higher, since the ACLR requirement value is satisfied, which is actually lower than the reference ACLR, the regulation of the supply voltage may be performed more conservatively. In an embodiment, $ACLR_{margin}$ is a real number greater than '0' as described above, so when $ACLR_{margin}$ is '0', $J_k$ may be set as Equation 2 below.

$$J_k = f_{ACLR}(v_s) + ACLR_k - ACLR_{ref} \qquad \text{[Equation 2]}$$

In Equations 1 and 2, the difference between $ACLR_k$ and $(ACLR_{ref} - ACLR_{margin})$ (or $ACLR_{ref}$) may correspond to the change level of the ACLR described above.

In operation S320, the power amplifier control device 100, 100a, or 100b finds $v_s$ in which the target variable $J_k$ becomes '0'. Since $ACLR_k$, $ACLR_{ref}$, and $ACLR_{margin}$ are already obtained values, searching for $v_s$ in which the target variable $J_k$ becomes '0' may mean searching for $f_{ACLR}(v_s)$, which has the same value as $(ACLR_{ref} - ACLR_{margin}) - ACLR_k$. In an embodiment, the power amplifier control device 100, 100a, or 100b searches for the output of the ACLR model having the same value as the change level of the ACLR.

When the output of the ACLR model is searched, the input corresponding to the output, that is, the change level $v_s$ of the supply voltage, will be obtained.

In operation S330, the power amplifier control device 100, 100a, or 100b regulates the supply voltage $V_{CC,k}$ based on the searched $v_s$. For example, the power amplifier control device 100, 100a, or 100b may obtain the regulated supply voltage corresponding to the current scenario through Equation 3 below.

$$V_{CC,k} = V_{CC,ref} - v_s \qquad \text{[Equation 3]}$$

Here, $V_{CC,k}$ is the regulated supply voltage for scenario k, and $V_{CC,ref}$ is the reference supply voltage. In an embodiment, the power amplifier control device 100, 100a, or 100b obtains the regulated supply voltage by subtracting the change level $v_s$ of the supply voltage from the reference supply voltage.

### **Digital** predistortion

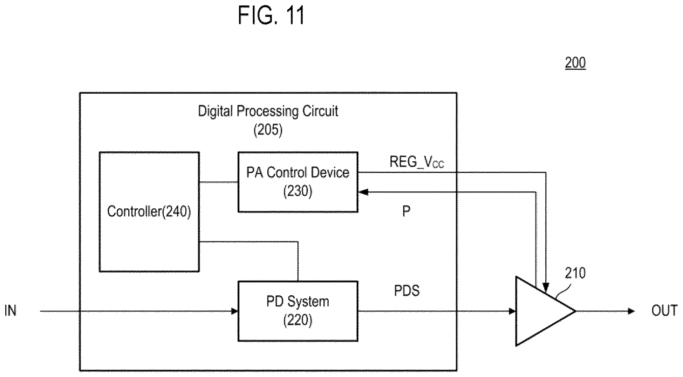

FIG. 11 illustrates an RF circuit according to an embodiment.

Referring to FIG. 11, a radio frequency (RF) circuit 200 according to an embodiment includes a digital processing circuit 205 and a power amplifier 210. The digital processing circuit 205 may control the overall operation of the power amplifier 210. The digital processing circuit 205 may include a predistortion (PD) system 220, a power amplifier control device 230, and a controller 240 (e.g., a control circuit).

The power amplifier 210 may be connected to the power amplifier control device 230 and the predistortion system 220, which are included in the digital processing circuit 205, and may amplify the input signal to output the output signal. The power amplifier 210 may compensate for nonlinearity through the predistortion system 220. Additionally, the power amplifier 210 may operate under control of the power amplifier control device 230 according to the above-described embodiments.

In an embodiment, the predistortion system 220 is configured to compensate for the nonlinearity of the power amplifier 210. The predistortion system 220 may perform a digital pre-distortion (DPD) to compensate for the nonlinearity of the power amplifier 210 in a digital domain.

The power amplifier 210 may have nonlinear characteristics due to nonlinear elements, and may thus have nonlinear distortion that distorts an output signal OUT. The predistortion system 220 may be connected to the input terminal of the power amplifier 210 to compensate for this nonlinearity, and may be designed such that an input signal IN has a distortion opposite to the nonlinear distortion of the power amplifier 210 by performing the predistortion on the input signal IN based on reference predistortion information.

The input signal IN of the predistortion system 220 may be a digital signal in a baseband, and therefore, the predistortion operation of the predistortion system 220 may be understood as being performed in the digital domain. The input signal IN may be, for example, an original signal to be amplified by the power amplifier 210 or a desired output signal that is the output signal OUT as the target signal.

Accordingly, even though the output signal OUT of the power amplifier 210 is amplified through the power amplifier 210 with nonlinear distortion, since the output signal OUT is already converted into a signal with opposite distortion through the predistortion system 220, the nonlinear characteristics may be compensated to have linear characteristics. Thus the ACLR of the power amplifier 210 may be optimized.

When the ACLR is optimized, the reference ACLR required for the RF circuit 200 may be satisfied relatively comfortably. Therefore, the RF circuit 200 of the present disclosure may increase the efficiency of the power amplifier 210 and satisfy the reference ACLR by regulating the supply voltage of the power amplifier 210 through the power amplifier control device 230.

In an embodiment, the power amplifier control device 230 measures the ACLR after the nonlinearity of the power amplifier 210 is compensated for through the predistortion system 220. The measurement of the ACLR may be performed on a case-by-case basis. The power amplifier control device 230 may obtain the change level of the supply voltage corresponding to the change level of the ACLR, which is defined as the difference between the reference ACLR and the measured ACLR, from the ACLR model, and may determine the regulated supply voltage. The power amplifier control device 230 may transfer the determined regulated supply voltage to the power amplifier 210, and the power amplifier 210 may operate based on the corresponding regulated supply voltage.

The controller 240 may be configured to control the power amplifier control device 230 and the predistortion system 220.

In an embodiment, the controller 240 sets a reference scenario of the power amplifier 210 for the predistortion operation of the predistortion system 220. The reference scenario of the power amplifier 210 may be defined as the operating environment of the power amplifier 210, which serves as a reference in relation to the predistortion and the supply voltage regulation. For example, the frequency of the target channel of the power amplifier 210 or the supply voltage of the power amplifier 210 may be included in the reference scenario.

In an embodiment, the controller 240 sets 'A', which is a parameter associated with the above-described error bar. The controller 240 may adjust the range of the error bar by setting the size of the 'A'. For example, the controller 240 may set the 'A' larger to allow power amplifier control device 230 to regulate the regulated supply voltage more conservatively.

In an embodiment, the controller 240 sets the reference supply voltage, the reference ACLR, and the ACLR margin of the power amplifier 210. For example, the controller 240 may set the size of the ACLR margin to allow the power amplifier control device 230 to regulate the supply voltage more conservatively.

According to the above-described embodiments, the RF circuit 200 of the present disclosure may perform efficient predistortion by utilizing reference predistortion information PDI as is. Additionally, in the present disclosure, when the ACLR is optimized according to nonlinearity compensation, the efficiency of the power amplifier 210 may be increased by regulating the supply voltage within a range where the ACLR satisfies the reference ACLR.

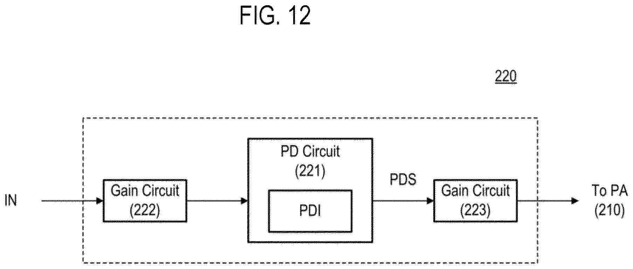

FIG. 12 illustrates a predistortion system according to an embodiment.

Referring to FIG. 12, a predistortion system 220 according to an embodiment includes a predistortion circuit (e.g., 221) and a gain providing circuit (e.g., 222).

The predistortion circuit 221 is configured to perform the predistortion on the input signal IN based on the reference predistortion information PDI and to output a predistortion signal PDS with respect to the input signal IN to the power amplifier 210. The predistortion operation of the predistortion circuit 221 may refer to a technique of performing the predistortion on the input signal IN according to a nonlinearity opposite to the nonlinearity characteristic of the power amplifier 210. According to the predistortion, the nonlinearity of the power amplifier 210 may be compensated.

The reference predistortion information PDI used for predistortion may be defined as information required to perform the predistortion on the nonlinearity of the power amplifier 210 when based on the power amplifier 210 having nonlinearity in any scenario (or environment). Since environmental factors such as the carrier frequency, temperature, and intensity of the output signal OUT of the RF circuit 200 may change under different scenarios, the power amplifier 210 in different scenarios may have different nonlinearities.

For example, when using the kth scenario as a reference, predistortion information for performing the predistortion on the nonlinearity under the kth scenario may be defined as the reference predistortion information PDI. Therefore, when the scenario changes, the nonlinearity of the power amplifier 210 will change, so the reference predistortion information PDI may be maintained as is, or may no longer be used.

For example, the predistortion information may include a predistortion Loop-Up Table (LUT) and a predistortion coefficient for the distortion compensation. In an embodiment, the predistortion LUT includes at least one of an amplitude modulation (AM)/AM LUT and an AM/phase modulation (PM) LUT. Accordingly, the reference predistortion information PDI may be defined as including the predistortion LUT and the predistortion coefficient configured to perform the predistortion on the nonlinearity in any scenario that serves as a reference.

The power amplifier 210 is connected to the output terminal of the predistortion circuit 221 and amplifies the power of the predistortion signal PDS, which is the output signal OUT of the predistortion circuit 221, to generate the output signal OUT. For example, the power amplifier 210 may have a gain G (where G is a real number). Since the power amplifier 210 has the nonlinear characteristic as described above, the output signal OUT may be distorted when there is no nonlinearity compensation operation such as the predistortion operation. The nonlinearity of the output signal OUT may be resolved by the predistortion circuit 221 described above.

When the scenario changes, the nonlinearity of the power amplifier 210 in the reference scenario and the nonlinearity of the power amplifier 210 in the changed scenario may be different from each other. Hereinafter, in the present disclosure, when the model of the power amplifier 210 in the reference scenario is defined as the reference model, the coefficient for defining the nonlinearity of the reference model will be defined as the nonlinearity coefficient.

Gain providing circuits 222 and 223 may be configured to provide a gain defined as the reciprocal of the nonlinear coefficient with respect to the power amplifier 210 described above to the input and output terminals of the predistortion circuit 221. In an embodiment, the gain providing circuits 222 and 223 may be configured to inversely compensate for the nonlinearity coefficient corresponding to the changed nonlinearity when the nonlinearity of the power amplifier 210 changes. When the scenario changes, the gain providing circuits 222 and 223 provided to the input and output terminals of the predistortion circuit 221 may adjust the gain to be provided to the input and output terminals of the predistortion circuit 221 using the reciprocal of the changed nonlinear coefficient to generate and adjusted gain and provide the adjusted gain to the predistortion circuit 221.

Then, when the scenario changes, the predistortion circuit 221 does not compensate for the nonlinearity by using different predistortion information PDI for each changing scenario, but may compensate for the nonlinearity while maintaining the reference predistortion information PDI. Therefore, the predistortion circuit 221 of the present disclosure maintains the reference predistortion information PDI even in changing scenarios, but may compensate for the nonlinearity in the changed scenario simply by providing the gain defined as the reciprocal of the nonlinearity coefficient.

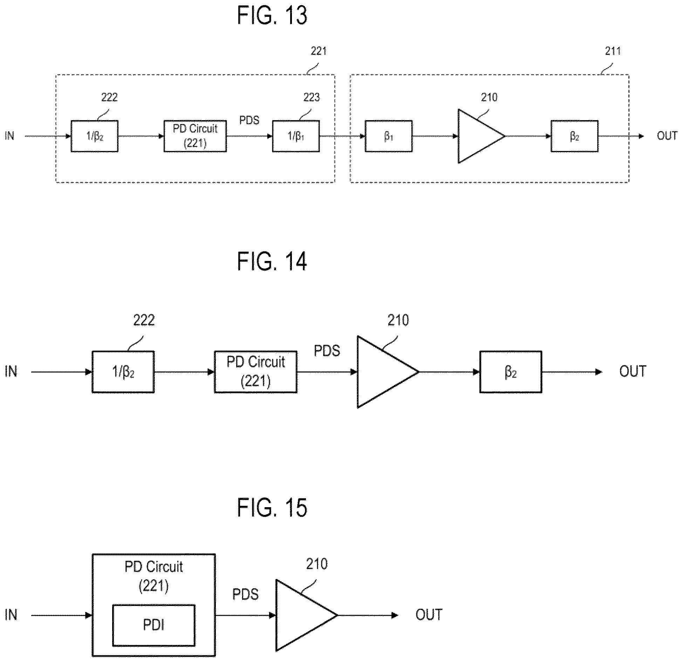

FIGS. 13 to 15 are diagrams for describing a predistortion operation of an RF circuit according to an embodiment.

First, referring to FIG. 13, when the power amplifier 210 included in the RF circuit 200 according to an embodiment operates under a changed scenario, the changed nonlinearity according to the scenario change may be modeled as a nonlinear coefficient. In an embodiment, the nonlinear coefficient includes a first nonlinear coefficient $\beta_1$ corresponding to the input terminal of the power amplifier 210 and a second nonlinear coefficient $\beta_2$ corresponding to the output terminal of the power amplifier 210. The first nonlinear coefficient $\beta_1$ and the second nonlinear coefficient $\beta_2$ may be positive real numbers.

In addition, the gain providing circuits 222 and 223 may be connected to the input and output terminals of the predistortion circuit 221. In an embodiment, the gain providing circuits 222 and 223 include the first gain providing circuit 222 and the second gain providing circuit 223 as illustrated. The first gain providing circuit 222 may be configured to provide a first gain defined as the reciprocal of the second nonlinear coefficient $\beta_2$ to the input terminal of the predistortion circuit 221. The second gain providing circuit 223 may be configured to provide a second gain defined as the reciprocal of the first nonlinear coefficient $\beta_1$ to the output terminal of the predistortion circuit 221. Therefore, the first gain providing circuit 222 may be configured to output the input signal IN multiplied by the first gain to the predistortion circuit 221, and the second gain providing circuit 223 may be configured to output the predistortion signal PDS multiplied by the second gain to the power amplifier 210.

Then, the input signal IN applied to the input terminal of the predistortion circuit 221 may be compensated by the first gain, and the predistortion signal PDS output from the output terminal of the predistortion circuit 221 may be compensated by the second gain.

Referring to FIG. 14, the first nonlinear coefficient $\beta_1$ may be compensated by the second gain provided from the second gain providing circuit 223. For example, the first nonlinear coefficient $\beta_1$ corresponding to the input terminal of the power amplifier 210 may be compensated when the predistortion signal PDS multiplied by the second gain is applied to the power amplifier 210.

Additionally, referring to FIG. 15, the second nonlinear coefficient $\beta_2$ may be compensated by the first gain provided from the first gain providing circuit 222. For example, the second nonlinear coefficient $\beta_2$ corresponding to the output terminal of the power amplifier 210 may be compensated by the first gain, which is multiplied by the input signal IN. The predistortion circuit 221 may compensate for nonlinearity in the changed scenario by using only the reference predistortion information PDI.

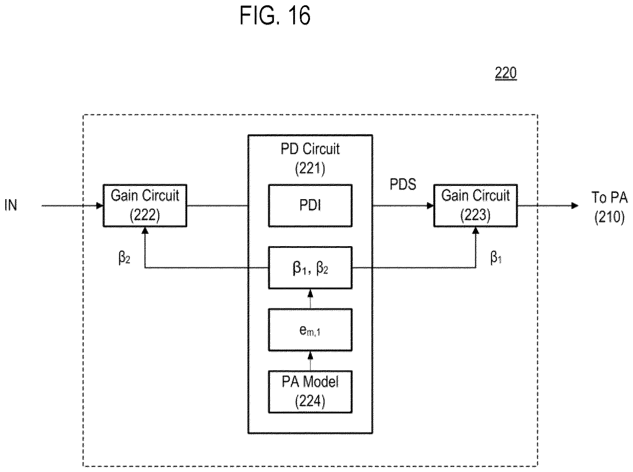

FIG. 16 illustrates a predistortion system 220 according to an embodiment.

Referring to FIG. 16, the predistortion circuit 221 included in the predistortion system 220 according to an embodiment performs a predistortion operation and a nonlinear coefficient estimation operation based on the reference predistortion information PDI.

In an embodiment, the predistortion circuit 221 obtains the reference predistortion information PDI. For example, the predistortion circuit 221 may be expressed as a memory polynomial (MP) model, and the predistortion circuit 221 may obtain the predistortion coefficient of the MP model as the reference predistortion information PDI by modeling the MP model.

In an embodiment, the predistortion circuit 221 models the power amplifier 210. For example, the power amplifier 210 may be expressed as an MP model or a memory less polynomial model, and the predistortion circuit 221 may obtain a reference model 224 of the power amplifier 210 by modeling the MP model or the memoryless polynomial model.

The reference predistortion information PDI and the reference model obtaining operation of the predistortion circuit 221 described above may be obtained under any scenario. For example, the obtained reference model 224 may be defined as $f_{PA}(\beta_1 \underline{x})$ (where $\beta_1$ is the first nonlinear coefficient and x is the input signal (i.e., the predistortion signal PDS) of the power amplifier 210).

In an embodiment, the predistortion circuit 221 estimates the nonlinear coefficient based on minimizing a first error $e_{m,1}$ that is defined based on the reference model 224 modeled from the power amplifier 210, a first output signal OUT, which is an actual output signal output from the power amplifier 210, and the nonlinear coefficient. For example, the first error $e_{m,1}$ may be defined as a Normalized Mean Square Error (NMSE) between the first output signal OUT and a second output signal that is an output when the first nonlinear coefficient $\beta_1$ and the second nonlinear coefficient $\beta_2$ are applied to the reference model 224. For example, the first error $e_{m,1}$ may be defined as Equation 4 below.

$$J(\beta_1, \beta_2) = \left\| \underline{y}' - \beta_2 \underline{f_{PA}}(\beta_1 \underline{x}) \right\|_2^2 \qquad \text{[Equation 4}$$

In this case, $J(\beta_1, \beta_2)$ may be defined as the first error $e_{m,1}$, $\underline{y}'$ may be defined as the first output signal OUT, and

$\beta_2\underline{f}_{PA}(\beta_1\underline{x})$ may be defined as the second output signal. The $\beta_2$ is the second nonlinear coefficient as described above. That is, the first error $e_{m,1}$ may be defined as a norm (e.g., Euclidean norm) of a difference vector between the first output signal OUT and the second output signal. Accordingly, the first error $e_{m,1}$ may have a nonlinear correlation with nonlinear coefficients.

When the nonlinear coefficient to be estimated is $\hat{\beta}_1$, $\hat{\beta}_2$ the estimated nonlinear coefficient may be defined as Equation 5 below.

$$\hat{\beta}_1, \hat{\beta}_2 = arg \min_{\beta_1, \beta_2} J(\beta_1, \beta_2) \qquad \text{[Equation 5]}$$

In addition, when Equation 5 is more generalized as a transpose matrix of $\hat{\beta}_1$, $\hat{\beta}_2$, the estimated nonlinear coefficient may be expressed as Equation 6 below.

$$\underline{\hat{\beta}} = arg\min_{\underline{\beta}} J\left(\underline{\beta}\right), \underline{\beta} \triangleq [\beta_1, \beta_2]^T \qquad \text{[Equation 6]}$$

Here, $[]^T$ refers to the transpose matrix.

That is, estimating $\hat{\beta}_1$, $\hat{\beta}_2$ is to find the first nonlinear coefficient $\beta_1$ and the second nonlinear coefficient $\beta_2$ that minimize the first error $e_{m,1}$. Accordingly, the predistortion circuit 221 may estimate $\hat{\beta}_1$, $\hat{\beta}_2$, which satisfies Equation 5, that is, minimizes the first error $e_{m,1}$.

The predistortion circuit 221 may estimate the nonlinear coefficient that satisfies Equation 5 or Equation 6 based on various embodiments.

In an embodiment, the predistortion circuit 221 estimates the nonlinear coefficient based on a linearization technique. In detail, when defined as $\underline{g}\left(\underline{\beta}\right) \triangleq \beta_2\underline{f}_{PA}(\beta_1\underline{x})$, $J(\beta_1, \beta_2)$, which is the first error $e_{m,1}$, may be defined as Equation 7 below with respect to a more generalized nonlinear coefficient $\beta$.

[Equation 7]

$$J\left(\underline{\beta}\right) = \left(\underline{y}' - \beta_2\underline{f}_{PA}(\beta_1\underline{x})\right)^H \left(\underline{y}' - \beta_2\underline{f}_{PA}(\beta_1\underline{x})\right) = \left(\underline{y}' - \underline{g}\left(\underline{\beta}\right)\right)^H \left(\underline{y}' - \underline{g}\left(\underline{\beta}\right)\right)$$

Here, $()^H$ refers to a Hermitian matrix.

$\underline{g}(\beta)$ may be approximated by Equation 8 below with respect to $\beta_{ini}$, which is the initial value for $\beta$.

[Equation 8]

$$\underline{g}\left(\underline{\beta}\right) \simeq \underline{g}\left(\underline{\beta}\right)\big|_{\underline{\beta}=\underline{\beta}_{ini}} + \frac{\partial \underline{g}\left(\underline{\beta}\right)}{\partial \underline{\beta}^T}\bigg|_{\underline{\beta}=\underline{\beta}_{ini}} \left(\underline{\beta} - \underline{\beta}_{ini}\right) = \underline{g}\left(\underline{\beta}_{ini}\right) + \underline{G}_{ini}\left(\underline{\beta} - \underline{\beta}_{ini}\right)$$

Here, $\underline{g}\left(\underline{\beta}_{ini}\right) \triangleq \underline{g}\left(\underline{\beta}\right)\big|_{\underline{\beta}=\underline{\beta}_{ini}}$ and may be defined as $\underline{G}_{ini} \triangleq \frac{\partial \underline{g}\left(\underline{\beta}\right)}{\partial \underline{\beta}^T}\bigg|_{\underline{\beta}=\underline{\beta}_{ini}}$. Therefore, by substituting Equation 8 into Equation 7, $J(\underline{\beta})$ may be defined as Equation 9 below.

[Equation 9]

$$J\left(\underline{\beta}\right) \simeq \left(\underline{y}' - \underline{g}\left(\underline{\beta}_{ini}\right) + \underline{G}_{ini}\left(\underline{\beta} - \underline{\beta}_{ini}\right)\right)^H \left(\underline{y}' - \underline{g}\left(\underline{\beta}_{ini}\right) + \underline{G}_{ini}\left(\underline{\beta} - \underline{\beta}_{ini}\right)\right) = \left(\underline{z} + \underline{G}_{ini}\Delta\underline{\beta}\right)^H \left(\underline{z} + \underline{G}_{ini}\Delta\underline{\beta}\right)$$

Here, $\underline{z} \triangleq \underline{y}' - \underline{g}\left(\underline{\beta}_{ini}\right)$ and may be defined as $\Delta\underline{\beta} \triangleq \underline{\beta} - \underline{\beta}_{ini}$. Therefore, an update value $\Delta\underline{\hat{\beta}}$ of the nonlinear coefficient for minimizing each term in Equation 9 may be defined as Equation 10 below.

$$\Delta\underline{\hat{\beta}} = -\left(\underline{G}_{ini}^H\underline{G}_{ini}\right)^{-1}\underline{G}_{ini}^H\underline{z} \qquad \text{[Equation 10]}$$

Therefore, the predistortion circuit 221 may estimate $\hat{\underline{\beta}}$, which is the nonlinear coefficient that satisfies Equation 6 based on Equation 11 below, which is defined by the initial value $\beta_{ini}$, the update value $\Delta\hat{\underline{\beta}}$ of the nonlinear coefficient defined by Equation 10, and $\mu$ (here, $0 < \mu < 1$), which is the weight information of the update value.

$$\hat{\underline{\beta}} = \underline{\beta}_{ini} + \mu\Delta\hat{\underline{\beta}} \qquad \text{[Equation 11]}$$

Here, the initial value $\beta_{ini}$ may be set in various ways. For example, since a value close to the actual value may not be known until $\hat{\underline{\beta}}$ is estimated, which is the nonlinear coefficient, the initial value $\beta_{ini}$ may be set to $[1\ 1]^T$ under situations where the changes in environmental factors changed for each scenario are not significantly different. For example, when the carrier frequency is changed in the changed scenario, but is not significantly different from the carrier frequency before the change (e.g., the difference between the carrier frequency after the change and the carrier frequency before the change is within a threshold, etc.), the initial value $\beta_{ini}$ may be set to $[1\ 1]^T$. However, this setting of the initial value $\beta_{ini}$ is only an example and may be set to various values for the purpose of faster estimating of the nonlinear coefficient that satisfies Equation 6,

Alternatively, according to various embodiments, the predistortion circuit 221 may estimate the nonlinear coefficient that minimizes the first error $e_{m,1}$ through various optimization techniques such as a Particle Swarm Optimization (PSO), a Gradient Descent, or Newton's method.

The predistortion circuit 221 may estimate the first nonlinear coefficient $\beta_1$ and the second nonlinear coefficient $\beta_2$ that minimize the first error $e_{m,1}$, may transfer the estimated first nonlinear coefficient $\beta_1$ to the second gain providing circuit 223, and may transfer the estimated second nonlinear coefficient $\beta_2$ to the first gain providing circuit 222.

Then, the first gain providing circuit 222 may receive the input signal IN and may output the input signal IN multiplied by the first gain to the predistortion circuit 221. Even though the scenario changes, the predistortion circuit 221 may output the predistortion signal PDS based on the reference predistortion information PDI rather than using the changed predistortion information. Thereafter, the second gain providing circuit 223 may multiply the predistortion signal PDS output from the predistortion circuit 221 by the second gain and may output the result to the power amplifier 210.

According to the above-described embodiments, the predistortion system 220 of the present disclosure may compensate for the nonlinearity due to scenario changes simply by adjusting gains of the gain providing circuits 222 and 223, based on the reference predistortion information PDI and the reference model 224 of the power amplifier 210. In particular, the predistortion system 220 of the present disclosure may estimate the nonlinear coefficient that minimizes the first error $e_{m,1}$, which is defined as the difference between the reference model 224 and the actual output signal OUT of the power amplifier 210, may use the reciprocal of the estimated nonlinearity coefficient as the gain of the gain providing circuits 222 and 223, and thereby effectively compensate for the nonlinearity. In a compensation process, the present disclosure enables predistortion without deterioration in predistortion performance due to changes (e.g., adjusting information such as the order of predistortion or the number of delay taps) in predistortion information PDI. In addition, by efficiently utilizing the reference predistortion information PDI, issues with storage space and time required for information extraction may also be resolved.

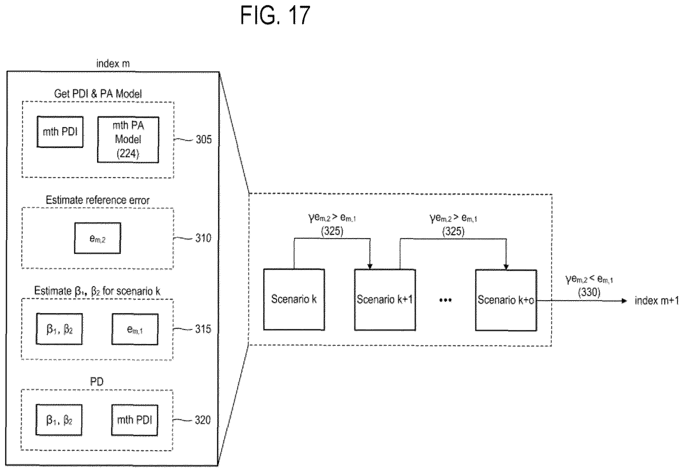

FIG. 17 is a diagram for describing an operation of a predistortion circuit according to an embodiment.

Referring to FIG. 17, the predistortion circuit 221 according to an embodiment operates on mth reference predistortion information PDI and the kth scenario (where 'm' and 'k' are natural numbers). Here, 'm' is an index of the reference predistortion information PDI, and changing of 'm' may mean that the reference predistortion information PDI is changed. The 'k' is an index of the scenario, and changing of 'k' may mean that the scenario (e.g., environmental factors such as the above-described carrier frequency, temperature, or intensity of the output signal OUT, etc.) is changed.

The predistortion circuit 221 may set 'm', which is the index of the reference predistortion information PDI, and the scenario index 'k'. For example, 'm' and 'k' may be set to an initial value of '0'.

The predistortion circuit 221 may obtain the mth reference predistortion information PDI and the mth reference model 224 of the power amplifier 210 (305).

The predistortion circuit 221 estimates a second error $e_{m,2}$, which is defined as the reference error (310). For example, the second error $e_{m,2}$ may be defined as a difference between the first output signal OUT, which is the actual output of the power amplifier 210 in the kth scenario, and the third output signal, which is the output of the reference model 224 obtained through 305. For example, the second error $e_{m,2}$ may be defined as $\left\| \underline{y}_k - \underline{f}_{PA,k}(\underline{x}) \right\|_2^2$. Here, $\underline{y}_k$ may be the first output signal OUT and $\underline{f}_{PA,k}(\underline{x})$ may be the third output signal. In this case, for indexing, the index of the mth reference model 224 and a model index of the kth power amplifier 210 may be fitted based on $\underline{f}_{PA,m}^{ref}(\cdot) = \underline{f}_{PA,k}(\cdot)$ (where $\underline{f}_{PA,m}^{ref}(\cdot)$ is the mth reference model 224, and $\underline{f}_{PA,k}(\cdot)$ is the model of the kth power amplifier 210).

The predistortion circuit 221 may define the first error $e_{m,1}$ and estimates the nonlinear coefficient by which the first error $e_{m,1}$ is minimized (315). For example, the first error $e_{m,1}$ may be defined by Equation 4. Estimation of nonlinear coefficients may be performed through various techniques according to the above-described embodiments.

The predistortion circuit 221 performs predistortion using the estimated nonlinear coefficients and the mth reference predistortion information PDI (320). For example, the reciprocal of the estimated nonlinear coefficient may be provided as the gain of the input and output terminals of the predistortion circuit 221 according to the above-described embodiments.

According to the above-described operations 305 to 320, the predistortion circuit 221 may secure the reference predistortion information PDI and the reference model 224 for the index 'm', and may apply them to the scenario 'k' to perform the predistortion. When changing from the kth scenario to the (k+1)th scenario, the predistortion circuit 221 may compare the first error $e_{m,1}$ with a value obtained by applying an error weight 'γ' to the second error $e_{m,2}$, Here, the error weight 'γ' may be defined as a real number greater than 1, as an example.

For example, the predistortion circuit 221 may perform the predistortion using the reference predistortion information PDI and the reference model 224 of the same index 'm' with respect to the (k+1)th scenario, based on the first error $e_{m,1}$ being less than the value obtained by applying the error weight 'γ' to the second error $e_{m,2}$ (325). In addition, since the scenario is changed, the nonlinear coefficient will also be estimated with respect to the (k+1)th scenario. When it is satisfied that the first error $e_{m,1}$ is less than the value obtained by applying the error weight 'γ' to the second error $e_{m,2}$ (325), the predistortion circuit 221 may perform the predistortion using the reference predistortion information PDI and the reference model 224 of the same index 'm' while continuously changing the scenario index.

In a (k+o)th scenario (where 'o' is a natural number), based on the first error $e_{m,1}$ being greater than the value obtained by applying the error weight 'γ' to the second error $e_{m,2}$ (330), the predistortion circuit 221 may redefine the reference predistortion information PDI and the reference model 224. In an embodiment, the predistortion circuit 221 changes the index 'm' to an index m+1 and newly performs operations 305 to 320 with respect to the changed index.

According to the above-described embodiments, the RF circuit of the present disclosure may perform the predistortion by applying one of the reference predistortion information PDI and one of the reference model 224 across multiple scenarios. In particular, at least one embodiment of the present disclosure may adaptively use the reference information by checking the extent of scenarios in which the reference information defined through the comparison of the first error $e_{m,1}$ and the value obtained by applying the error weight 'γ' to the second error $e_{m,2}$ may be utilized.

FIG. 17 is illustrative of merely one embodiment and the disclosure is not limited thereto. In detail, the RF circuit of the present disclosure may dynamically set the reference predistortion information PDI and/or the reference model 224 in consideration of scenarios and errors as illustrated in FIG. 17, but may also set the reference predistortion information PDI and/or the reference model 224 in advance for each scenario according to the embodiment.

For example, when there are a plurality of operating frequency intervals of the RF circuit, that is, multiple sub-bands, the reference predistortion information PDI and/or the reference model 224 may be preset based on a center frequency of each sub-band. In this case, the RF circuit may perform the predistortion using the preset reference predistortion information PDI and/or the preset reference model 224 according to the operating sub-band.

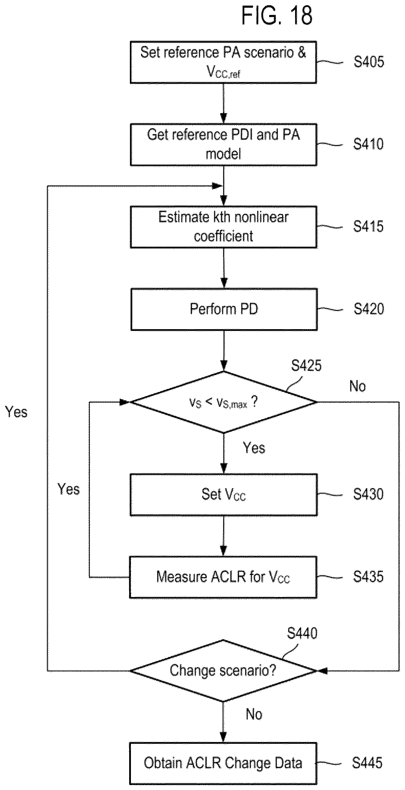

FIG. 18 is a flowchart illustrating a method for a predistortion and an ACLR measurement of an RF circuit according to an embodiment.

Referring to FIG. 18, in operation S405, the RF circuit 200 sets the scenario of the reference power amplifier and the reference supply voltage $V_{CC,ref}$. In operation S410, the RF circuit 200 gets the reference predistortion information and the reference model. In operation S415, the RF circuit 200 estimates the nonlinear coefficient with respect to the kth scenario in the specific scenario 'k'. For example, the nonlinear coefficient may be estimated to minimize the first error $e_{m,1}$. In operation S420, the RF circuit 200 performs the predistortion based on the gain defined as the reciprocal of the nonlinear coefficient and the reference predistortion information.

Through operations S405 to S420, the nonlinearity of the power amplifier may be compensated and the ACLR may be optimized. In particular, the predistortion may be performed for each scenario 'k' through operations S415 to S420.

Thereafter, the RF circuit 200 may regulate the supply voltage through operations S425 to S445. In operation S425, the RF circuit 200 determines whether the change level vs of the current supply voltage is less than the maximum value $v_{s,max}$. When the change level vs of the supply voltage is less than the maximum value $v_{s,max}$, the RF circuit 200 may set the supply voltage Vcc in operation S430. In operation S435, the RF circuit 200 may measure the ACLR from the power amplifier operating at a set supply voltage.

The change level vs of the current supply voltage may range from '0' to the maximum value $v_{s,max}$. In detail, operations S425 to S435 may all be performed for a range of 0 or more to the maximum value $v_{s,max}$, and when the change level vs of the current supply voltage reaches the maximum value $v_{s,max}$, operation S440 may be performed.

In operation S440, the RF circuit 200 determines whether to change the scenario. When the scenario is changed, the RF circuit 200 may repeat operations S415 to S435 with respect to the power amplifier in the changed scenario. In detail, the RF circuit 200 may repeatedly perform the predistortion and the ACLR measurement in the changed scenario.

When the scenario is not changed, in operation S445, the power amplifier control device obtains the ACLR change data based on the plurality of obtained ACLRs.

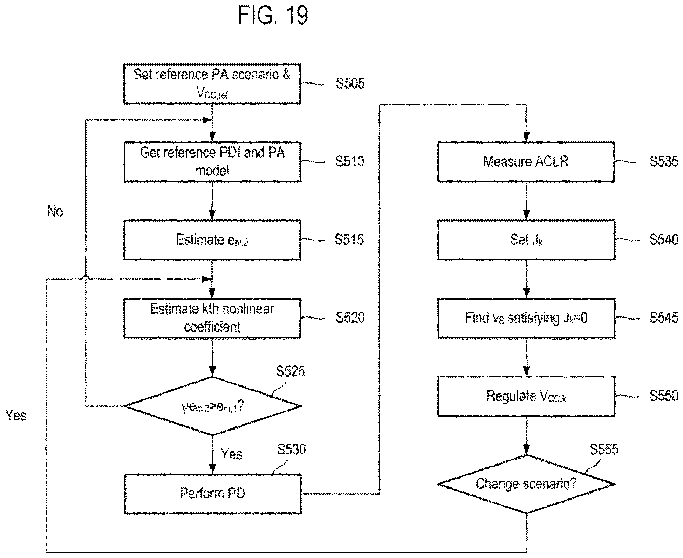

FIG. 19 is a flowchart illustrating a method for a predistortion and a supply voltage regulation of an RF circuit according to an embodiment.

Referring to FIG. 19, in operation S505, the RF circuit 200 sets the scenario of the reference power amplifier and the reference supply voltage. In operation S510, the RF circuit 200 gets the reference predistortion information and the reference model. In operation S515, the RF circuit 200 estimates the second error $e_{m,2}$, For example, the second error $e_{m,2}$ may be defined as $\left\| \underline{y}_k - \underline{f}_{PA,k}(\underline{x}) \right\|_2^2$. In addition, the RF circuit 200 may set the index of the mth reference model and the model index of the kth power amplifier to be the same for indexing.

In operation S520, the RF circuit 200 estimates the nonlinear coefficient.

In operation S525, the RF circuit 200 compares the first error $e_{m,1}$ with the value obtained by applying the error weight '$\gamma$' to the second error $e_{m,2}$, The error weight '$\gamma$' may be defined as a real number greater than ' 1', for example, and may be set in advance or may be set by the predistortion circuit 221.

When it is determined that the first error $e_{m,1}$ is less than the value obtained by applying the error weight '$\gamma$' to the second error $e_{m,2}$ in operation S525, in operation S530, the RF circuit 200 may perform the predistortion based on the gain defined by the reciprocal of the nonlinear coefficient and the reference predistortion information.

Alternatively, when it is determined in operation S525 that the first error $e_{m,1}$ is greater than the value obtained by applying the error weight '$\gamma$' to the second error $e_{m,2}$, in operation S235, the RF circuit 200 may increase the index 'm' by '1'. Thereafter, the RF circuit 200 may repeat operations S510 to S525 with respect to the new index 'm'.

After predistortion is performed through operation S530, in operation S535, the RF circuit 200 measures the ACLR for the kth scenario. In operation S540, the RF circuit 200 sets the target variable $J_k$. In operation S545, the RF circuit 200 searches for $v_s$ at which the target variable $J_k$ becomes '0'. In operation S550, the RF circuit 200 regulates the supply voltage based on the searched $v_s$. In operation S555, the RF circuit 200 determines whether to change the scenario. When the scenario is changed, the RF circuit 200 may repeat operations S520 to S555 with respect to the power amplifier in the changed scenario. The RF circuit 200 may perform the predistortion and supply voltage regulation in the changed scenario.

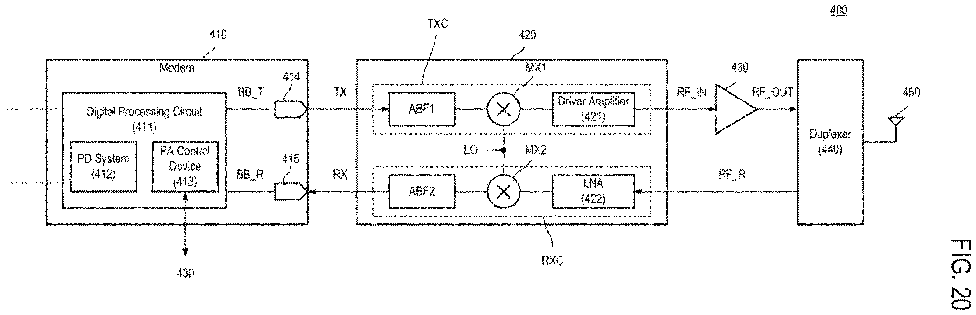

FIG. 20 illustrates a wireless communication device according to an embodiment.

Referring to FIG. 20, a wireless communication device 400 according to an embodiment may include a MODEM 410, an RF integrated circuit (RFIC) 420, a power amplifier 430, a duplexer 440, and an antenna 450.

The MODEM 410 may include a digital processing circuit 411, an analog to digital converter (ADC) 414, and a digital to analog converter (DAC) 415. The MODEM 410 may process a baseband signal BB_T (e.g., including I signal and Q signal) containing information to be transmitted through the digital processing circuit 411 according to various communication methods. The MODEM 410 may process a baseband signal BB_R received from the digital processing circuit 411 according to various communication methods.

For example, the MODEM 410 may process a signal to be transmitted or a received signal in compliance with a communication scheme such as Orthogonal Frequency Division Multiplexing (OFDM), Orthogonal Frequency Division Multiple access (OFDMA), Wideband Code Multiple Access (WCDMA), or High Speed Packet Access+ (HSPA+). In addition, the MODEM 410 may process the baseband signal BB_T or BB_R in compliance with various types of communication methods. For example, these communication methods may include those in which technology for modulating or demodulating the amplitude and frequency of the baseband signal BB_T or BB_R is applied.

The digital processing circuit 411 may perform various processing operations on baseband signals in the digital domain. The digital processing circuit 411 may perform the predistortion operation according to the various embodiments described above. The digital processing circuit 411 may include a predistortion system 412 for performing predistortion operations. In addition, the digital processing circuit 411 may include a power amplifier control device 413 for performing supply voltage regulation operations.

The predistortion system 412 may perform the predistortion operation according to the above-described embodiments. For example, the predistortion system 412 may be configured to perform the predistortion on the baseband signal BB_T based on the reference predistortion information. For example, the input and output terminals of the predistortion system 412 may be provided with the gain providing circuit of FIG. 12 described above. The gain providing circuit may be configured to provide the gain defined as the reciprocal of the nonlinear coefficient with respect to the power amplifier 430 to the input and output terminals of the predistortion system 412. Through the predistortion system 412, the baseband signal BB_T may be distorted in advance to compensate for the nonlinearity of the power amplifier 430. In particular, according to the present disclosure, the nonlinearity of the power amplifier 430 in changed scenarios may be compensated for through the gain providing circuit.

The power amplifier control device 413 may perform the supply voltage regulation operation according to the above-described embodiments. For example, the power amplifier control device 413 may measure the ACLR of the power amplifier 430, may determine the regulated supply voltage from the ACLR model, which is defined based on the change level of the supply voltage of the power amplifier and the change level of the ACLR defined as the difference between the reference ACLR and the measured ACLR, and may transmit the regulated supply voltage to the power amplifier 430. In particular, when the ACLR is optimized as the nonlinearity of the power amplifier 430 is compensated for through the predistortion system 412, the power amplifier control device 413 may determine the regulated supply voltage that allows the power amplifier to operate more efficiently while still satisfying the reference ACLR even though the ACLR is slightly degraded.

The ADC 415 and the DAC 414 may be provided in numbers of at least one or more. The MODEM 410 may convert the baseband signal BB_T to an analog signal using the DAC 414 to generate a transmission signal TX. Additionally, the MODEM 410 may receive a reception signal RX as an analog signal from the RFIC 420. In addition, the MODEM 410 may digitally convert the reception signal RX through the ADC 415 provided therein and may extract the baseband signal BB_R, which is a digital signal. For example, the reception signal RX may be differential signals including a positive signal and a negative signal.

The RFIC 420 may generate an RF input signal RF_IN by performing frequency up-conversion on the transmission signal TX or may generate the reception signal RX by performing frequency down-conversion on an RF reception signal RF_R. In detail, the RFIC 420 may include a transmission circuit TXC for frequency up-conversion, a reception circuit RXC for frequency down-conversion, and a local oscillator LO.

In an embodiment, the transmission circuit TXC includes a first analog baseband filter ABF1, a first mixer MX1, and a driver amplifier 421. For example, the first analog baseband filter ABF1 may include or be a low pass filter.

The first analog baseband filter ABF 1 may filter the transmission signal TX received from the MODEM 410 to generate a filtered signal and may provide the filtered signal to the first mixer MX1. In addition, the first mixer MX1 may perform frequency up-conversion to convert the frequency of the transmission signal TX from the baseband to a high frequency band using the frequency signal provided by the local oscillator LO. Through this frequency up-conversion, the transmission signal TX may be provided to the driver amplifier 421 as the RF input signal RF_IN. The driver amplifier 421 may amplify the power of the RF input signal RF_IN to generate an amplified result and provide the amplified result to the power amplifier 430.

The power amplifier 430 may be supplied with a DC voltage or a variable power voltage (i.e., a dynamically variable output voltage), and may secondarily amplify the power of the RF input signal RF_IN based on the supplied power voltage to generate an RF output signal RF_OUT. The power voltage may correspond to the above-described supply voltage, and the power amplifier 430 may operate with the regulated supply voltage under the control of the power amplifier control device 413. In addition, the power amplifier 430 may provide the generated RF output signal RF_OUT to the duplexer 440.

In an embodiment, the reception circuit RXC includes a second analog baseband filter ABF2, a second mixer MX2, and a low-noise amplifier (LNA) 422. For example, the second analog baseband filter ABF2 may include or be a low pass filter.

The LNA 422 may amplify the RF reception signal RF_R provided from the duplexer 440 so as to be provided to the second mixer MX2. In addition, the second mixer MX2 may perform frequency down-conversion to convert the frequency of the reception signal RF_R from the high frequency band to the baseband using the frequency signal provided by the local oscillator LO. Through this frequency down-conversion, the RF reception signal RF_R may be provided as the reception signal RX to the second analog baseband filter ABF2, and the second analog baseband filter ABF2 may filter the reception signal RX so as to be provided to the MODEM 410.

For reference, the wireless communication device 400 may transmit a transmit signal across a plurality of frequency bands (e.g., different frequency bands) by using a carrier aggregation (CA). In addition, for this purpose, the wireless communication device 400 may include a plurality of power amplifiers 430 that power amplify a plurality of RF input signals RF_IN respectively corresponding to a plurality of carrier waves. For example, the carrier waves may be for different frequency bands. However, in the embodiment of the present disclosure, for convenience of description, the description will be given as the number of power amplifiers is "1".

The duplexer 440 may be connected to the antenna 450 and may separate the transmission frequency from the reception frequency. In detail, the duplexer 440 may separate the RF output signal RF_OUT provided from the power amplifier 430 for each frequency band so as to be provided to the corresponding antenna 450. In addition, the duplexer 440 may provide an external signal provided from the antenna 450 to the LNA 422 of the reception circuit RXC of the RFIC 420. For example, the duplexer 440 may include a front end module with integrated duplexer (FEMiD).

The wireless communication device 400 may include a switch structure capable of separating the transmission frequency and the reception frequency instead of the duplexer 440. Also, the wireless communication device 400 may include a structure implemented with the duplexer 440 and a switch for the purpose of separating the transmission frequency and the reception frequency. However, for convenience of description, in an embodiment of the present disclosure, the description will be given as the duplexer 440 capable of separating the transmission frequency and the reception frequency being included in the wireless communication device 400.

The antenna 450 may transmit the RF output signal RF_OUT frequency-separated by the duplexer 440 to the outside or provide the RF reception signal RF_R received from the outside to the duplexer 440. For example, the antenna 450 may include, but is not limited to, an array antenna.

Each of the MODEM 410, the RFIC 420, the power amplifier 430, and the duplexer 440 may be individually implemented with an integrated circuit, a chip, or a module. Also, the MODEM 410, the RFIC 420, the power amplifier 430, and the duplexer 440 may be together mounted on a printed circuit board (PCB). However, embodiments of the present disclosure are not limited thereto. In some embodiments, at least a part of the MODEM 410, the RFIC 420, the power amplifier 430, and the duplexer 440 may be implemented with a single communication chip.

In addition, the wireless communication device 400 illustrated in FIG. 20 may be included in a wireless communication system that uses a cellular network such as 5G, LTE and may also be included in a wireless local area network (WLAN) system or any other wireless communication system. While a configuration of the wireless communication device 400 is illustrated in FIG. 20, embodiments of the disclosure are not limited thereto, and may be variously configured in compliance with a communication protocol or a communication scheme.

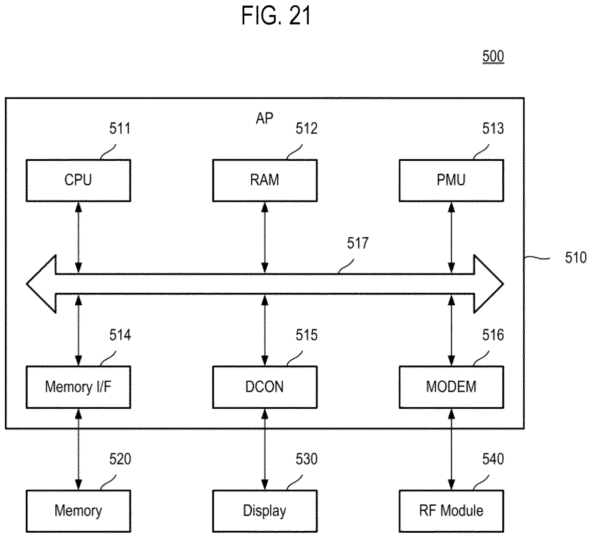

FIG. 21 illustrates an electronic device according to an embodiment.

Referring to FIG. 21, an electronic device 500 may be, for example, a mobile terminal and may include an application processor (AP) 510, a memory 520, a display 530, and an RF module 540. In addition, the electronic device 500 may further include various components such as a lens, a sensor, and an audio module.

The AP 510 may be implemented with a system on chip (SoC) and may include a central processing unit (CPU) 511, a random-access-memory (RAM) 512, a power management unit (PMU) 513, a memory interface (I/F) 514, a display controller (DCON) 515, a MODEM 516, and a system bus 517. In addition, the AP 510 may further include various intellectual properties. The AP 510 may be integrated with a function of a MODEM chip therein, which is referred to as a "ModAP".

The CPU 511 may generally control operations of the AP 510 and the electronic device 500. The CPU 511 may be configured to execute at least one instruction stored in the RAM 512, and may control the operation of each component of the AP 510 using the instruction. Also, the CPU 511 may be implemented with a multi-core. The multi-core may be one computing component having two or more independent cores.

According to embodiments, the CPU 511 may measure the ACLR of the power amplifier included in the RF module 540 and may determine a regulated supply voltage from the ACLR model. For example, the CPU 511 may model the ACLR model to have an upper limit value of the ACLR change level range corresponding to the standard deviation of the ACLR change level as a dependent variable, with respect to the change level of the supply voltage. The CPU 511 may store the modeled ACLR model in the memory 520.

For example, the CPU 511 may determine the change level of the supply voltage when the change level of the ACLR corresponds to the upper limit value in the ACLR model, and may determine the difference between the reference supply voltage and the change level of the supply voltage as the regulated supply voltage.

For example, the CPU 511 may obtain the change level of the supply voltage when the change level of the ACLR corresponds to a specific value from the ACLR model stored in the memory, and may determine the difference between the reference supply voltage and the change level of the supply voltage as the regulated supply voltage.

The RAM 512 may temporarily store programs, data, or at least one instruction. For example, the programs and/or data stored in the memory 520 may be temporarily stored in the RAM 512 under control of the CPU 511 or depending on a booting code. The RAM 512 may be implemented with a dynamic-RAM (DRAM) or a static-RAM (SRAM).

The PMU 513 may manage power of each component of the AP 510. The PMU 513 may also determine an operating situation of each component of the AP 510 and may control an operation thereof.

The memory interface 514 may control overall operations of the memory 520 and may control data exchange of the memory 520 with each component of the AP 510. Depending on a request of the CPU 511, the memory interface 514 may write data in the memory 520 or may read data from the memory 520. For example, the memory 520 may store various information (e.g., the ACLR data set, the ACLR change data, the ACLR model, the reference ACLR, the ACLR margin value, etc.) according to the above-described embodiments. For example, the memory 520 may store the ACLR model defined according to the above-described embodiments.

The display controller 515 may provide the display 530 with image data to be displayed on the display 530. The display 530 may be implemented with a flat panel display, such as a liquid crystal display (LCD) or an organic light emitting diode (OLED) display, or a flexible display.

For wireless communication, the MODEM 516 may modulate data to be transmitted so as to be appropriate for a wireless environment and may recover received data. The MODEM 516 may perform digital communication with the RF module 540.

The MODEM 516 may be implemented with the MODEM 410 described above with reference to FIG. 20. Alternatively, at least one of the power amplifier control device 413 (100, 100a, 100b) and the predistortion system 412 (220) described above with reference to FIGS. 1, 6, 7, 11, 12, and 16 may be implemented in the MODEM 516.

The RF module 540 may convert a high-frequency signal received through an antenna into a low-frequency signal and may transmit the converted low-frequency signal to the MODEM 516. In addition, the RF module 540 may convert a low-frequency signal received from the MODEM 516 into a high-frequency signal and may transmit the converted high-frequency signal to the outside of the electronic device 500 through the antenna. Also, the RF module 540 may amplify or filter a signal.

The RFIC 200, the supply modulator 300, the power amplifier PA, the duplexer 400, and the antenna ANT described with reference to FIG. 20 may be implemented in the RF module 540.

For this reason, in the electronic device 500, wide band communication may be possible, and power consumption for communication may be reduced.

According to an embodiment of the present disclosure, a power amplifier control device and a method of operating the same that increase the efficiency of a power amplifier may be provided.

The above descriptions are specific embodiments for carrying out the present disclosure. Embodiments in which a design is changed simply or which are easily changed may be included in the present disclosure as well as an embodiment described above. In addition, technologies that are easily changed and implemented by using the above embodiments may be included in the present disclosure. While the present disclosure has been described with reference to embodiments thereof, it will be apparent to those of ordinary skill in the art that various changes and modifications may be made thereto without departing from the scope of the present disclosure as set forth in the following claims.

**Claims**

1. A power amplifier control device comprising:

   a measuring circuit configured to measure an adjacent channel leakage ratio (ACLR) of a power amplifier; and
   a supply voltage regulation circuit configured to determine a regulated supply voltage from an ACLR model defined based on a change level of a supply voltage of the power amplifier and a change level of a measured ACLR defined as a difference between a reference ACLR and the measured ACLR, and to transfer the regulated supply voltage to the power amplifier.

2. The power amplifier control device of claim 1, wherein the measuring circuit is configured to calculate the measured ACLR based on a difference between an adjacent channel power measured from an adjacent channel of a target channel of the power amplifier and a target channel power measured from the target channel.

3. The power amplifier control device of claim 1 or 2, further comprising:
   a modeling circuit configured to obtain change data from a dataset including a plurality of ACLRs, and to model the ACLR model based on a correlation between the change level of the supply voltage and the change data.

4. The power amplifier control device of claim 3, wherein the change level of the supply voltage is based on a difference between a reference supply voltage and the regulated supply voltage.

5. The power amplifier control device of claim 3 or 4, wherein the change data includes at least one of the change level of the measured ACLR with respect to the dataset, a mean of the change level of the measured ACLR, and a standard deviation of the change level of the measured ACLR.

6. The power amplifier control device of claim 5, wherein the modeling circuit is configured to model the ACLR model to have, as a dependent variable, an upper limit value of a range of the change level of the measured ACLR corresponding to the standard deviation of the change level of the measured ACLR with respect to the change level of the supply voltage.

7. The power amplifier control device of claim 6, wherein the supply voltage regulation circuit is configured to determine the change level of the supply voltage when the change level of the measured ACLR in the ACLR model corresponds to the upper limit value, and to determine a difference between a reference supply voltage and the change level of the supply voltage as the regulated supply voltage.

8. The power amplifier control device of claim 6, wherein the supply voltage regulation circuit is configured to determine the change level of the supply voltage when a difference between the change level of the measured ACLR and a margin value in the ACLR model corresponds to the upper limit value, and to determine a difference between a reference supply voltage and the change level of the supply voltage as the regulated supply voltage.

9. The power amplifier control device of any of claims 3 to 8, wherein the measuring circuit is configured to measure the plurality of ACLRs based on a change in at least one of a frequency of a target channel and the supply voltage with respect to the power amplifier.

10. The power amplifier control device of any preceding claim, further comprising:
a memory configured to store the ACLR model.

11. The power amplifier control device of claim 10, wherein the supply voltage regulation circuit is configured to obtain from the memory the change level of the supply voltage when the change level of the measured ACLR corresponds to a specific value in the ACLR model, and to determine a difference between a reference supply voltage and the change level of the supply voltage as the regulated supply voltage.

12. A method of operating a power amplifier control device, the method comprising:

measuring an adjacent channel leakage ratio (ACLR) of a power amplifier;
determining a regulated supply voltage from an ACLR model defined based on a change level of a supply voltage of the power amplifier and a change level of a measured ACLR defined as a difference between a reference ACLR and the measured ACLR; and
transferring the regulated supply voltage to the power amplifier.

13. The method of claim 12, further comprising:

obtaining change data from a dataset including a plurality of ACLRs; and
modeling the ACLR model based on a correlation between the change level of the supply voltage and the change data.

14. The method of claim 13, wherein the modeling of the ACLR model includes modeling the ACLR model to have, as a dependent variable, an upper limit value of a range of the change level of the measured ACLR corresponding to a standard deviation of the change level of the measured ACLR with respect to the change level of the supply voltage.

15. The method of claim 14, wherein the determining of the regulated supply voltage includes determining the change level of the supply voltage when the change level of the measured ACLR in the ACLR model corresponds to the upper limit value, and determining a difference between a reference supply voltage and the change level of the supply voltage as the regulated supply voltage.

# FIG. 1

# FIG. 2

# FIG. 3

FIG. 4

FIG. 5

FIG. 6

# FIG. 7

FIG. 8

```
┌────────────────────────────────────┐
│                                    │
│   Measure ACLR of power amplifier  │ ── S110
│                                    │
└────────────────────────────────────┘
                  │
                  ▼
┌────────────────────────────────────┐
│                                    │
│  Determine regulated V_CC from ACLR│ ── S120
│              model                 │
└────────────────────────────────────┘
                  │
                  ▼
┌────────────────────────────────────┐
│ Transmit regulated V_CC to power   │ ── S130
│            amplifier               │
└────────────────────────────────────┘
```

FIG. 9

S210

$v_S < v_{S,max}$ ?

No

Yes

Set $V_{CC}$ — S220

Measure ACLR for $V_{CC}$ — S230

— S205

Adjust $v_S$ — S240

S250

Yes

Change scenario?

No

Obtain ACLR Change Data — S260

FIG. 10

| | |
|---|---|
| Set $J_k$ | S310 |
| ↓ | |
| Find $v_S$ satisfying $J_k=0$ | S320 |
| ↓ | |
| Regulate $V_{CC,k}$ | S330 |

FIG. 11

FIG. 12

220

FIG. 13

221

222                                                              223                                    211

                                                    PDS                      210

IN →  [ 1/β₂ ] → [ PD Circuit (221) ] → [ 1/β₁ ] → [ β₁ ] → ▷ → [ β₂ ] → OUT


FIG. 14

222                                                    210

IN → [ 1/β₂ ] → [ PD Circuit (221) ] →PDS→ ▷ → [ β₂ ] → OUT


FIG. 15

          [ PD Circuit (221)
                [ PDI ] ]              210

IN →  ————————————→ PDS → ▷ → OUT

# FIG. 16

# FIG. 17

# FIG. 18

```
┌─────────────────────────┐
│  Set reference PA scenario & │ ── S405
│        V_CC,ref         │
└─────────────────────────┘
            │
            ▼
┌─────────────────────────┐
│  Get reference PDI and PA │ ── S410
│         model           │
└─────────────────────────┘
            │
            ▼
┌─────────────────────────┐
│  Estimate kth nonlinear  │ ── S415
│       coefficient        │
└─────────────────────────┘
            │
            ▼
┌─────────────────────────┐
│       Perform PD         │ ── S420
└─────────────────────────┘
            │
            ▼          S425
         ◇ v_S < v_S,max ?  ◇ ── No
            │ Yes
            ▼
┌─────────────────────────┐
│        Set V_CC          │ ── S430
└─────────────────────────┘
            │
            ▼
┌─────────────────────────┐
│   Measure ACLR for V_CC  │ ── S435
└─────────────────────────┘
            │
            ▼          S440
         ◇  Change scenario?  ◇
            │ No
            ▼
┌─────────────────────────┐
│   Obtain ACLR Change Data │ ── S445
└─────────────────────────┘
```

$v_S < v_{S,max}$ ?

Yes

Yes

No

# FIG. 19

Set reference PA scenario & $V_{CC,ref}$ — S505

Get reference PDI and PA model — S510

Estimate $e_{m,2}$ — S515

Estimate kth nonlinear coefficient — S520

$\gamma e_{m,2} > e_{m,1}$? — S525

No

Yes

Perform PD — S530

Measure ACLR — S535

Set $J_k$ — S540

Find $v_S$ satisfying $J_k=0$ — S545

Regulate $V_{CC,k}$ — S550

Change scenario? — S555

FIG. 20

# FIG. 21

500

AP

**Europäisches Patentamt**
**European Patent Office**
**Office européen des brevets**

# EUROPEAN SEARCH REPORT

**Application Number**

EP 24 19 6651

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/173762 A1 (AN YONGJUN [KR] ET AL) 2 June 2022 (2022-06-02) | 1,2,12 | INV. H03F1/02 |
| A | * figures 1-8 * <br> * paragraphs [0001] - [0168] * | 6-8,14, 15 | H03F1/32 <br> H03F3/195 <br> H03F3/213 |
| X | US 2018/124716 A1 (KRISHNAN SUDARSAN [US] ET AL) 3 May 2018 (2018-05-03) | 1-5,9-13 | H03F3/24 |
| A | * figures 1-7 * <br> * paragraphs [0001] - [0077] * | 6-8,14, 15 | |
| X | US 2013/107926 A1 (XIA YING [US] ET AL) 2 May 2013 (2013-05-02) | 1,2,12 | |
| A | * figures 1-4 * <br> * paragraphs [0001] - [0066] * | 6-8,14, 15 | |
| X | JP 2008 098830 A (MATSUSHITA ELECTRIC IND CO LTD) 24 April 2008 (2008-04-24) | 1,2,12 | |
| A | * figures 1-3 * <br> * paragraphs [0001] - [0055] * | 6-8,14, 15 | |

**TECHNICAL FIELDS SEARCHED (IPC)**

H03F

The present search report has been drawn up for all claims

| Place of search | Date of completion of the search | Examiner |
|---|---|---|
| The Hague | 15 January 2025 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 6651

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2025

| Patent document cited in search report | | Publication date | Patent family member(s) | | Publication date |
|---|---|---|---|---|---|
| US 2022173762 | A1 | 02-06-2022 | KR 20210022351 | A | 03-03-2021 |
| | | | US 2022173762 | A1 | 02-06-2022 |
| | | | WO 2021034030 | A1 | 25-02-2021 |
| US 2018124716 | A1 | 03-05-2018 | NONE | | |
| US 2013107926 | A1 | 02-05-2013 | EP 2559103 | A1 | 20-02-2013 |
| | | | US 2013107926 | A1 | 02-05-2013 |
| | | | WO 2012170825 | A1 | 13-12-2012 |
| JP 2008098830 | A | 24-04-2008 | NONE | | |

EPO FORM P0459

For more details about this annex : see Official Journal of the European Patent Office, No. 12/82